# EUROPEAN PATENT APPLICATION

(11) **EP 4 776 065 A1**
(43) Date of publication of application: **15.07.2026**
(21) Application number: 25191995.7
(22) Date of filing: 25.07.2025
(51) Int. Cl.: G03F 1/72, G03F 7/20

(54) **METHOD FOR CORRECTING ERRORS IN PHOTOLITHOGRAPHIC MASKS WITH LOCALLY SEPARATED DENSITY CHANGES**

(71) Applicant: Carl Zeiss SMS Ltd., 2015600 Misgav (IL)
(72) Inventor: DMITRIEV, Vladimir, 2015600 Misgav (IL); GORHAD, Kujan, 2015600 Misgav (IL); SUFRIN, Yael, 2015600 Misgav (IL)
(74) Representative: Lang, Christian

(57) **Abstract**

The present invention relates to a method of correcting placement errors on and/or optical transmission errors of a photolithographic mask (1) for a projection exposure apparatus for microlithography comprising a substrate (2) and photolithographic imaging structures (3,23) formed on the substrate, in which method a laser beam (5,25) is used to introduce into the substrate (2) a plurality of local density variations each defining a pixel (4,24), in order to correct placement errors of the structures and/or optical transmission errors, wherein the pixels are introduced in at least two separately arranged pixel arrangement regions which are arranged outside a centre plane (8) of the substrate (2,22) or the mask (1,20), the pixels (4, 24) being arranged in the pixel arrangement regions in such a way that, with a defined correction of placement errors on and/or of optical transmission errors of the mask (1, 20), an undesired change in shape of the mask (1, 20) is minimised by the introduction of the local density changes..

## Description

### BACKGROUND OF THE INVENTION

### FIELD OF THE INVENTION

The present invention relates to a method for correcting placement errors or so called registration errors on and/or optical transmission errors of a photolithographic mask for a projection exposure system for microlithography which can be used for imaging structures in a projection exposure system, wherein the mask comprises a substrate and structures formed on the substrate, and wherein in the method at least one local density change, preferably a plurality of local density changes, each defining a pixel, are introduced into the substrate by means of a laser beam in order to correct placement errors and/or transmission errors.

### STATE OF THE ART

For the production of microstructured or nanostructured components in electrical engineering or microsystems technology, microlithographic processes are used in which structures arranged on a mask or a reticle are imaged onto a photoresist in a miniaturised manner by means of projection exposure systems in order to produce the structures on the components to be produced, such as wafers and the like, by means of corresponding microlithographic processes. Since smaller and smaller structures are to be produced, projection exposure systems are now used that work with working light in the wavelength spectrum of extreme ultraviolet light (EUV - light). Accordingly, the photolithographic masks must meet high requirements for the exactness of their geometric shape.

However, such photolithographic masks may have placement errors of pattern or structure elements, so that some of the structures are not imaged exactly at the predetermined position in the photoresist.

For transmissive photolithographic masks, the homogeneity of optical transmission across the mask area is an important parameter. A variation of the optical transmission over the area of the photolithographic mask results in a corresponding variation of the local optical dose applied to the photoresist placed on the wafer. The variation in locally applied dose results in a fluctuation or variation in the structural dimensions of a pattern element in the developed photoresist. The uniformity of a structural element across the area of the photolithographic mask is called critical dimension uniformity (CDU).

To this end, it is known that by introducing local density variations into a portion of the substrate of the mask in the area of the placement errors, the corresponding structures can be shifted to compensate for the placement errors. Local density variations can also be used to correct transmission errors that affect critical dimensional uniformity. This is described for example in DE 10 2006 054 820 A1, DE 10 2011 078 927 A1, US 9,436,080 B2 or WO 2015/144700 A2.

The local density variations in the mask substrate are achieved by local and temporary heating or melting of the substrate material by means of lasers and in particular pulsed lasers, such as femtosecond lasers. In the area where the material has been temporarily melted or correspondingly heated, the density of the substrate is locally reduced, whereby a volume area whose density is locally changed by a laser beam is referred to as a pixel.

The so-called writing of the pixels is usually done with a laser from the back of the mask, which is opposite the side where the structures of the mask are located and which, in the case of a reflective mask for EUV microlithography, has a corresponding reflective coating for the EUV radiation.

The pixels are usually created in the area of or along a mid-plane of the substrate or mask to avoid undesired changes of the form of the mask, especially bending of the substrate or mask due to the local density changes. However, the spacing of the pixels relative to the structures of the mask imposes a limitation on the correction of the defects, since the local transmission of the deformation is limited and thus sufficient deformation may not be possible at the surface of the substrate or in the area of the structures to be imaged. The local resolution of the correction of transmission errors is also more limited when the distance between the pixels and the structures to be imaged is larger.

### DISCLOSURE OF THE INVENTION

### TASK OF THE INVENTION

It is therefore the object of the present invention to provide a method for correcting placement errors on and/or optical transmission errors of a photolithographic mask for a projection exposure system for microlithography, which can be used for imaging structures in a projection exposure system, in which both the error correction with respect to local resolution and/or effective correction of placement errors and the simultaneous avoidance of changes in the shape of the mask are optimised. In particular, the method should be simple and reliable to perform.

### TECHNICAL SOLUTION

This task is solved with a method having the features of claim 1. Advantageous embodiments of the invention are the subject of the dependent claims.

The invention starts from the realisation that a method for correcting placement errors on and/or optical transmission errors of a photolithographic mask for a projection exposure system for microlithography can be used by introducing local density changes into a substrate of the mask. In a corresponding mask having a substrate and photolithographic imaging structures formed on the substrate, the method comprises introducing, by means of a laser beam, a plurality of local density changes, each defining a pixel, into the substrate by local heating and/or melting to correct placement errors of the structures and/or optical transmission errors. According to the invention, the pixels are introduced in at least two pixel arrangement regions arranged separately from one another, which are arranged outside a centre plane or mid-plane of the substrate or of the mask, in order to achieve, on the one hand, a defined, in particular maximum or optimum correction of placement errors on and/or of optical transmission errors of the mask and, on the other hand, to minimise an undesired change in shape, such as a bending of the mask, by introducing the local density changes.

Maximum or optimal correction in this context also means that errors can also be corrected with a high local resolution.

The substrate can be formed as a thin disc which has a length and width or a diameter which are greater than the thickness of the disc by an integral multiple, in particular 5 to 50 times, the width and length of the disc or the areas parallel to the diameter defining the main surfaces. The structures to be imaged can be arranged on one of the main surfaces, wherein in particular the pixel arrangement areas can be formed as layers parallel to the main surfaces, which can comprise single-layer or multi-layer pixels, so that two or three-dimensional pixel arrangements can be present in the pixel arrangement areas.

At least one or exactly one pixel arrangement region may be arranged in a substrate half from the centre plane to the main surface with the structures to be imaged, in particular in the vicinity of the main surface with the structures to be imaged, preferably at a distance of one fifth to two thirds of the distance of the main surface with the structures to the centre plane. In the same way, at least one or exactly one pixel arrangement area can be arranged in a substrate half from the centre plane to the rear side, which is opposite the main area with the structures, in particular in the vicinity of the rear side, preferably at a distance of one fifth to two thirds of the distance of the rear side to the centre plane.

The pixels can be introduced into the substrate by means of a laser beam, whereby different operating modes can be selected in order to form the pixels in a desired manner and, in particular, also to generate pixels of different shapes or having different properties. Accordingly, different laser beam parameters can be set, such as the position of the focal point in the substrate, the numerical aperture of the laser beam, the wavelength of the laser light used, the writing speed of the laser beam in terms of the number of pixels per time, the focal point size of the laser beam, the beam diameter at the incident surface, the energy of the laser beam, the beam intensity of the laser beam, the intensity profile of the laser beam, the pulse duration, the repetition rate, the pulse power and the pulse power density for pulsed lasers.

The mask to be corrected may be a transmission mask, in particular for a projection exposure system operating with working light in the range of the deep ultraviolet wavelength spectrum (deep ultraviolet DUV), in particular in the range of 120 nm to 250 nm, wherein a transmission mask is transilluminated by the working light of a projection exposure system. The method can also be used for a reflection mask, wherein the working light of a projection exposure system is reflected by the mask. In particular, the method can be used for a mask for a projection exposure system that operates with working light in the range of the extreme ultraviolet wavelength spectrum (extreme ultraviolet EUV), in particular in the range of 10 nm to 100 nm.

In order to achieve an optimal correction of the placement errors and / or of optical transmission errors of the mask, the distribution and / or properties of the pixels and / or the laser beam parameters can be determined, whereby the determination of the distribution and / or the properties of the pixels and / or the laser beam parameters can be carried out taking into account the bending to be expected by the pixels. For this purpose, the corresponding errors can first be recorded or measured in order to then calculate and / or optimise the pixels to be generated.

To simplify the process and reduce the required calculations, two identical arrangements of pixels can be formed in each half of the substrate from the centre plane, in particular symmetrically with respect to position and / or arrangement to the centre plane.

In the case of a transmission mask, the determination of the distribution and / or characteristics of the pixels and / or the laser beam parameters can be made taking into account the transmission behaviour of the areas with pixels, the undesired change in shape or bending of the substrate due to the introduction of the pixels and the correction of the placement errors and / or optical transmission errors.

In the case of a reflective mask, the determination of the distribution and / or characteristics of the pixels and / or the laser beam parameters can be made taking into account the undesired change in shape or bending of the substrate due to the insertion of the pixels and the correction of the placement errors.

In at least one or exactly one pixel arrangement area in a substrate half from the centre plane to the front and/or rear side of transmission masks, pixels can be arranged in particular in the vicinity of the rear side exclusively or preferably only in one or more lateral parts of the pixel arrangement area for error correction and/or avoidance of the undesired change in shape or bending of the mask. The lateral parts in which pixels can preferably or exclusively be arranged may in particular correspond to the inactive parts of the mask which are not transilluminated by the working light of the projection exposure system. In particular, pixels with a strong density change can be arranged in these lateral parts of the pixel arrangement areas.

For generating the correction of the placement errors and/or of optical transmission errors, the distribution and/or properties of the pixels and/or the laser beam parameters can be determined in such a way that in at least one pixel arrangement region in a substrate half from the centre plane to the rear side facing the main surface with the structures, in particular in the vicinity of the rear side, pixels are arranged for the correction of errors which require a low spatial resolution, and/or that in at least one region in a substrate half from the centre plane to the main surface with the structures to be imaged, in particular in the vicinity of the main surface with the structures to be imaged, pixels are arranged for the correction of errors which require a high spatial resolution.

### SHORT DESCRIPTION OF THE FIGURES

The attached drawings show in a purely schematic manner in
- Figure 1: a partial cross-section through a transmission mask with a representation of a two-dimensional pixel generation according to the state of the art,
- Figure 2: a partial cross-section through a transmission mask with a representation of a three-dimensional pixel generation according to the state of the art,
- Figure 3: a partial cross-section through a reflective mask showing prior art pixel generation,
- Figure 4: a partial cross-section through a transmission mask with a representation for the local resolution of the error correction with central pixel arrangement,
- Figure 5: a partial cross-section of a first embodiment of a transmission mask showing two-dimensional pixel arrangements according to the present invention,
- Figure 6: a partial cross-section through a second embodiment of a transmission mask with a representation of three-dimensional pixel arrangements according to the present invention,
- Figure 7: a partial cross-section through a reflective mask showing two-dimensional pixel arrangements according to the present invention,
- Figure 8: a partial cross-section through a reflective mask showing three-dimensional pixel arrangements according to the present invention, and in
- Figure 9: a representation of the surface expansion response as a function of the arrangement frequency of the pixels (pixel writing frequency or writing wavelength) for a conventional three-dimensional pixel arrangement in the centre of the substrate and an arrangement of two separate pixel arrangements outside the centre plane area according to the invention.

### EXAMPLES AND EMBODIMENTS

Further advantages, characteristics and features of the present invention will become apparent in the following detailed description of examples and embodiments. However, the invention is not limited to these embodiments.

Fig. I shows a schematic cross-sectional view of a transmissive photolithographic mask 1. The mask 1 comprises a substrate 2 having a front surface (front side) or major surface 11 and a back surface (rear side) or major surface 12. The substrate 2 shall be transparent to the wavelength used for exposing a photoresist on a wafer. The exposure wavelength may be in the deep ultraviolet (DUV) spectral region of the electromagnetic spectrum, particularly around 193 nm. The substrate material is typically quartz. The substrate has typical side dimensions with a width and a length of about 150 mm x 150 mm and a thickness or height of, for example, about 6 mm. The substrate 2 of the photolithographic mask 1 has on its front side or front main surface 11 pattern elements or structures 3 to be imaged, for example made of chromium, which image on the photoresist the structural elements to be fabricated, which are included in semiconductor devices. The part of the substrate 2 of the photolithographic mask 1 which carries the pattern elements 3 is referred to as the active part of the mask, while the edge region or peripheral part which does not have pattern or structural elements 3 is referred to as the non-active part 7.

A laser beam 5 illuminates the substrate 2 of the mask 1 through the rear surface or main surface 12 of the substrate 2 in order to introduce pixels 4 with local density changes into the substrate 2 in the region of a centre plane 8, which separates a first half 9 of the substrate 2 from a second half 10 of the substrate 2, by heating or melting in order to change the transmission behaviour of the mask 1 when it is irradiated with working light from a projection exposure system, for example to correct CD errors in the imaging. The pixels 4 are generated in a single layer along the centre plane 8 as a two-dimensional pixel arrangement 6 to avoid bending of the substrate 2 about an axis of rotation perpendicular to the image plane.

The arrangement 6 as well as the distribution of the pixels 4 and their formation can be adjusted in such a way that the change in the transmission behaviour of the working light of the projection exposure system is changed in such a way that the errors to be corrected are optimally corrected.

Various laser beam parameters can be selected to set the desired formation of the pixels 4, such as the position of the focal point in the substrate, the numerical aperture of the laser beam, the wavelength of the laser beam light used, the writing speed of the laser beam in terms of the number of pixels 4 per time, the focal point size of the laser beam, the beam diameter at the incident surface, the energy of the laser beam, the beam intensity of the laser beam, the intensity profile of the laser beam, the pulse duration, the repetition rate, the pulse power and the pulse power density for pulsed lasers.

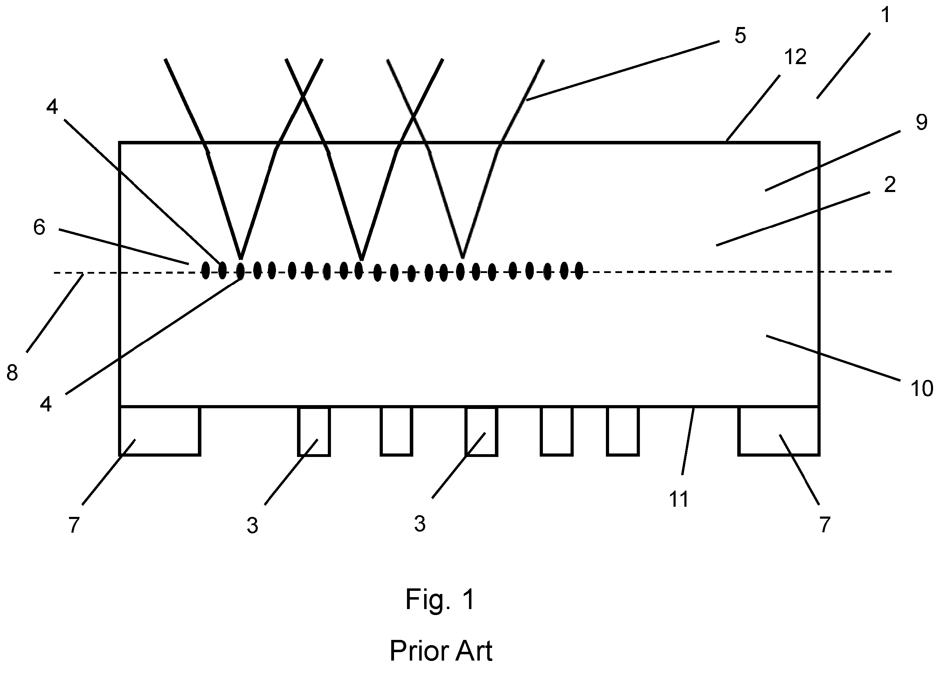

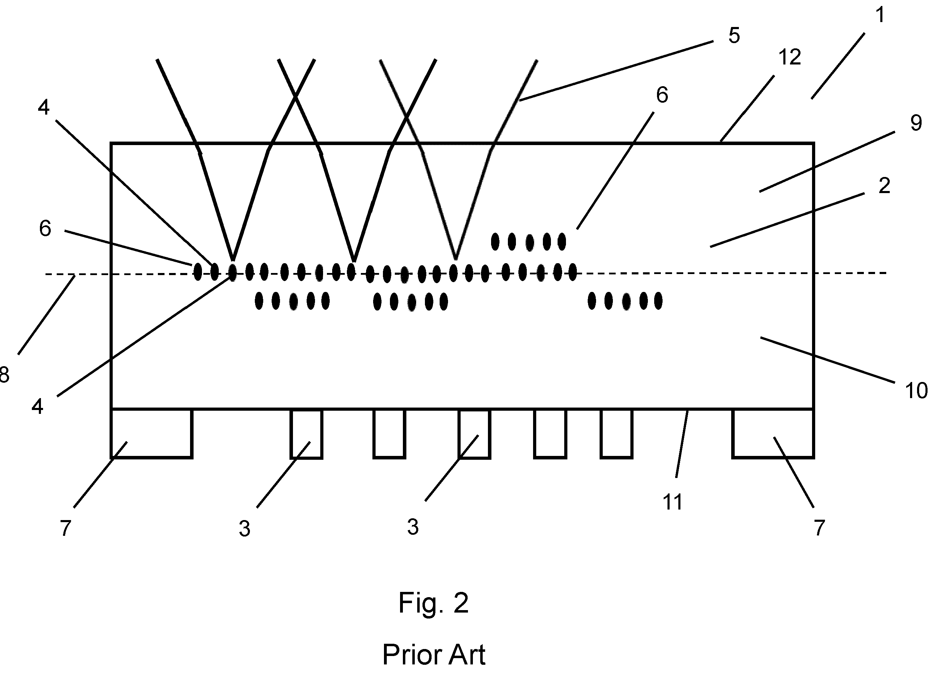

Figure 2 shows another example of a transmissive mask 1 in which the transmission behaviour in a projection exposure system is changed by introducing pixels 6 in such a way that placement errors of the structures 3 to be imaged on the mask 1 and/or optical transmission errors of the mask 1 are eliminated as far as possible. Identical components or representations of Figure 2 compared to Figure 1 are designated with identical reference signs and are not described again to avoid repetition.

The example of figure 2 shows instead of the two-dimensional pixel arrangement of figure 1 a three-dimensional pixel arrangement 6 of the pixels 4, which is done in three layers in the area of the centre plane 8, in order to again avoid a possible bending of the substrate due to the introduction of the density changes by the pixels 4.

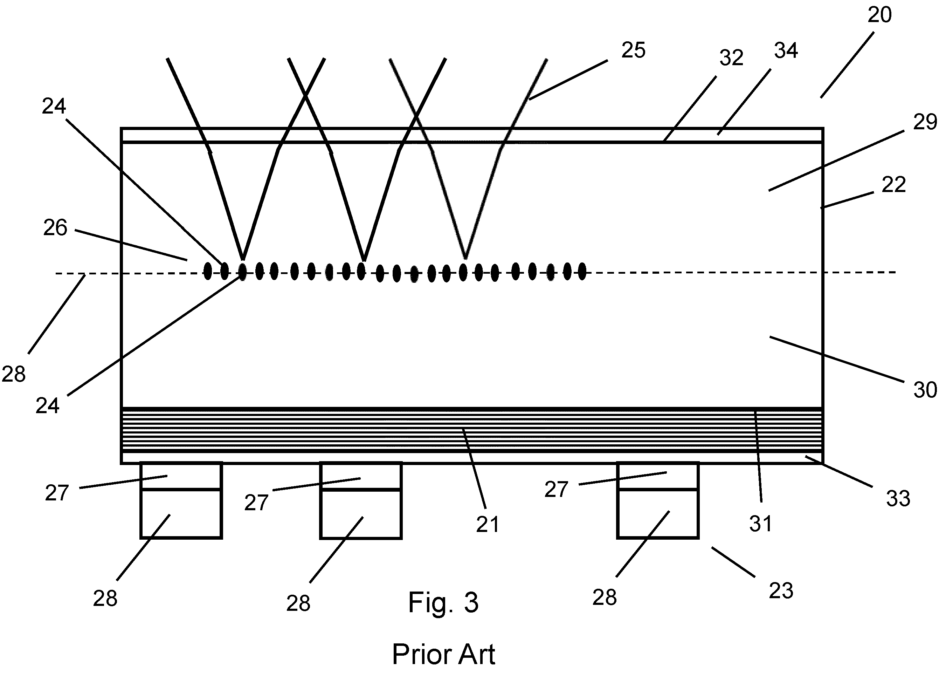

Figure 3 shows a partial cross-section of a reflective mask 20 as used for the microlithographic production of micro- or nanostructured components in electrical engineering or microsystems technology in projection exposure systems operated with working light in the wavelength range of extreme ultraviolet light (EUV light), in particular for a working light or exposure wavelength in the range of 10 nm to 15 nm. In contrast to the photolithographic mask 1 of Fig. 1, the mask 20 is a reflective optical component based on a reflective coating 21 with a multilayer mirror structure. The reflective mask 20 has a substrate 22 formed of, for example, fused silica or glass-ceramic materials having a low coefficient of thermal expansion. Typically, the substrate 22 of the EUV mask 20 also has lateral dimensions of approximately 152 mm x 152 mm and a thickness or height of substantially 6.35 mm.

On a front main surface 31 of the substrate 20, a reflective coating 21 is applied, for example consisting of a plurality of alternating partial layers of molybdenum and silicon, which form a so-called Bragg reflector to reflect the working light of a projection exposure system. The reflective coating 21 comprises, for example, about 40 pairs of alternating molybdenum and silicon layers. The thickness of each Mo layer is, for example, 4.15 nm and that of the Si layer is 2.80 nm.

Structures 23 are formed on the side of the mask 20 with the reflective coating 21, which are to be imaged with the aid of a projection exposure system and produced in the component to be manufactured by microlithographic processes. To form the structures 23, a buffer structure 27 and an absorbent structure 28 are deposited on a cover layer 33 of the reflective coating 21. The buffer layer 27 may be deposited to protect the multilayer mirror structure 21 during processing, for example during etching of the absorbent structure 28. Possible buffer structure materials include, for example, fused silica (Si02), silicon-oxygen nitride (SiON), ruthenium (Ru), chromium (Cr) and/or chromium nitride (CrN). The absorbing structure 28 consists of a material with a large absorption constant for photons in the EUV wavelength range. Examples of these materials are chromium (Cr) and/or tantalum nitride (TaN). Typically, a thickness of about 50 nm is sufficient to absorb substantially all EUV photons incident on the absorbing structure 28. In contrast, most of the photons that hit the cover layer 33 are reflected as photons.

Opposite the reflective coating 21, which may have a cover layer 33 to protect the reflective coating 21, an electrically conductive back coating 34 is provided on the back of the mask 2. The conductive coating 34 serves to fix the photolithographic mask 20 to the EUV scanner by the action of electrostatic forces.

As described in detail, for example, in DE 10 2011 078 927 A1 or WO 2015/144700 A2 or US 9,436,080 B2, the contents of which are incorporated herein by reference in their entirety, a plurality of local density variations, so-called pixels 24, may be generated in the substrate 22 to correct placement errors of the structures 23 to be imaged.

In the examples of Figures 1 to 3, it is shown that to create a pixel 4,24 or a local density variation, a laser beam 5,25 is focused on an area within the substrate 2,22 of the mask 1,20 to create a local density variation by locally heating or melting the substrate material to create a so-called pixel 4,24.

In order to introduce the laser light 25, and in particular light pulses of a laser beam 25, locally into the substrate 22 of the EUV mask 20, the conductive coating 34 on the rear substrate surface 32 of the EUV mask 20 is formed by a transparent conductive coating 34, which may, for example, consist of indium tin oxide (ITO). The term transparent conductive coating means that the coating 34 is optically transparent to light in the corresponding wavelength range. Alternative materials for transparent conductive coatings include fluor tin oxide (FTO) and/or aluminium zinc oxide (AZO) and/or antimony tin oxide (ATO). These materials can be easily applied to the back substrate surface 32 of a fused silica substrate 22 and have a conductivity high enough to attach the mask 20 to the EUV scanner. The transparent conductive coating 34 allows the fully fabricated EUV mask 20 to be irradiated with light pulses from a laser beam through the back substrate surface 32. The transparent conductive coating 34 also allows the EUV mask 20 to be exposed to ultrashort laser pulses during its fabrication process when the coating 34 is placed on the mask blank or on the back substrate surface 32 in a first step of the mask fabrication process.

As can also be seen in Figure 3, a plurality of such pixels 24 can be created in the substrate 22 to effect a displacement of structures and thus correction of placement errors of the structures provided on the reflection side 31 of the mask 22. In the example of Figure 3, a two-dimensional pixel arrangement 26 is shown, but a three-dimensional pixel arrangement is also conceivable, similar to Figure 2 for the transmissive mask 1.

As described in DE 10 2011 078 927 A1, the number and position of the pixels as well as their properties and the way in which the pixels are produced can be optimised by modifying the radiation parameters in such a way that optimum correction of placement errors is achieved.

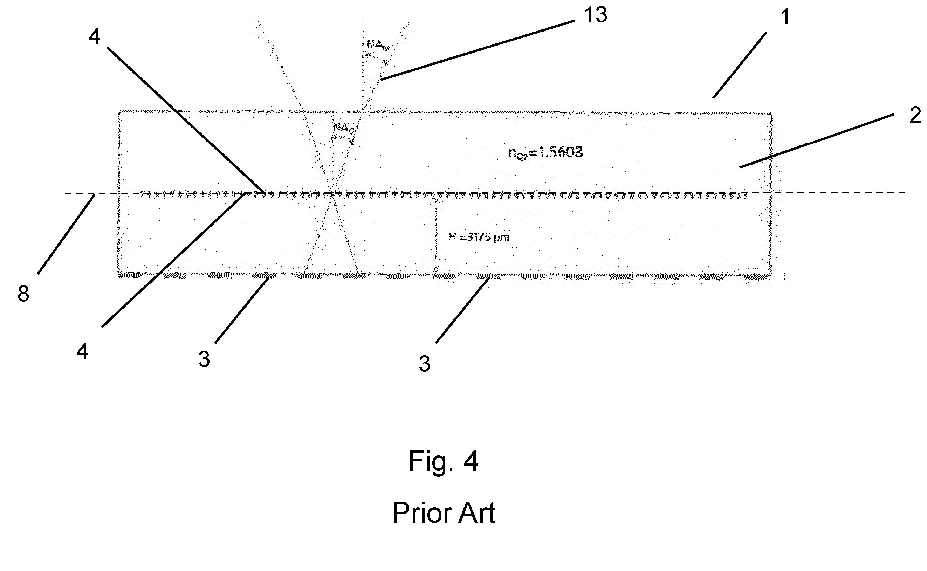

However, the correction of placement errors and / or transmission errors by introducing local density changes also has limitations. With the usually chosen arrangement of the pixels 4 along a centre plane 8, the influence of the density changes on the deformation at the surface for the correction of placement errors is limited by the corresponding distance of the pixels from the structures to be corrected and depending on the frequency of the introduced pixels, i.e. the spatial formation frequency or wavelength. When correcting transmission errors, the resolution at the location of the structures 3 is defined by the numerical aperture of the illumination of the mask 1 in the projection exposure system, as can be seen in Figure 4. With a numerical aperture of the wafer illumination NAw = 1.35 and the corresponding numerical aperture for the mask illumination NA_{M} = MAw /4 = 0.34 and the refraction index of glass with n_{Qz} = 1.5608, the result is a spillover size S = 2*NA_{M} * H/n_{Qz} = 1373 µm, if the distance H of the pixel from the structures 3 is 3175 µm. This makes it clear that the spatial lateral resolution of the correction of corresponding transmission errors is limited.

The invention now proposes to solve this problem by no longer arranging the corresponding pixels 4, 24 and pixel arrangements 6, 26 in the area of the centre plane 8, but instead providing two separate areas with corresponding pixel arrangements, but with the area around the centre plane or mid-plane 8 no longer having pixels 4, 26.

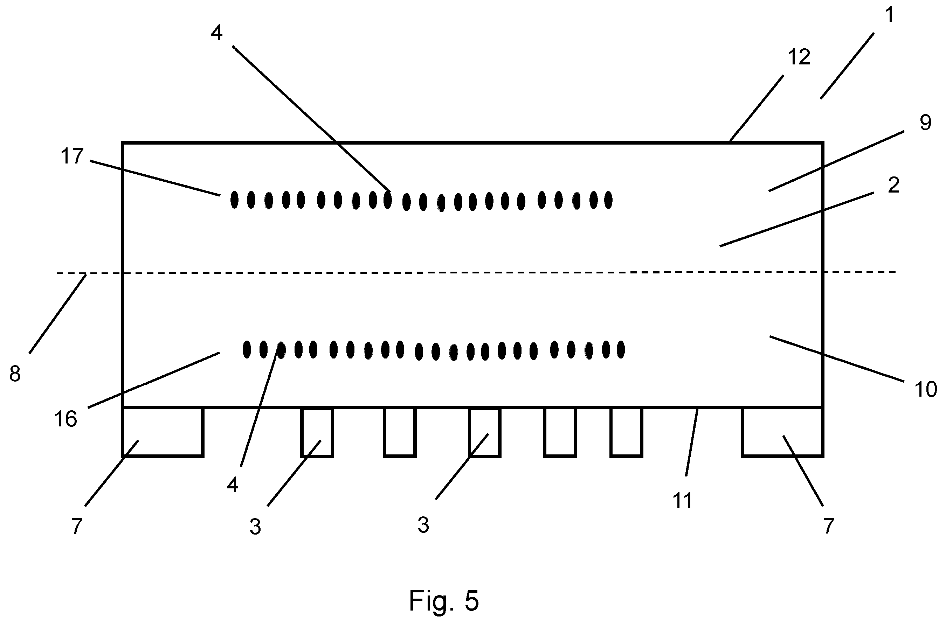

This is shown in Figure 5 for a transmissive mask 1 in which the same reference signs as in Figures 1 and 2 are used for identical components, so that a repeated description is unnecessary. However, what is different from the examples in the prior art according to Figures 1 and 2 is that two separate pixel arrangements 16 and 17 are arranged with respect to the centre plane 8, whereby the first pixel arrangement 16 in the vicinity of the structures 3 to be imaged enables a higher local resolution of the correction of transmission errors, while the second pixel arrangement 17, which is arranged in the vicinity of the rear side 12, largely compensates for a possible bending of the substrate 2 by the first pixel arrangement 16.

For the transmissive mask 1, the transmission through the substrate 2 with the introduced pixel arrangements 16 and 17 must take place in a defined manner and, at the same time, the placement errors and / or transmission errors are to be eliminated with the least possible bending of the mask 1. For this purpose, the pixels 4 in the two pixel arrangements 16 and 17 can be arranged and formed in a suitable manner, whereby different laser parameters can be selected according to the parameters of the laser for writing the pixels. Accordingly, in at least two modes for writing each pixel layer, at least four degrees of freedom exist in order to be able to satisfy the four conditions, namely illumination light transmission through the first pixel arrangement 16 close to the structures 3 to be imaged, illumination light transmission through the second pixel arrangement 17 close to the back side 12, minimum bending of the substrate 2 and improvement of the placement errors and/or transmission errors or overlay errors

Depending on the focus, emphasis can be either on minimising the corresponding errors or on reducing possible bending of the mask.

To reduce the computational effort, one approach can be to make the first pixel arrangement 16. and the second pixel arrangement 17 identical, possibly accepting a lower error correction. Furthermore, it is also possible to combine the flatness of the mask in combination with the optimisation of the error correction of placement errors and / or transmission errors.

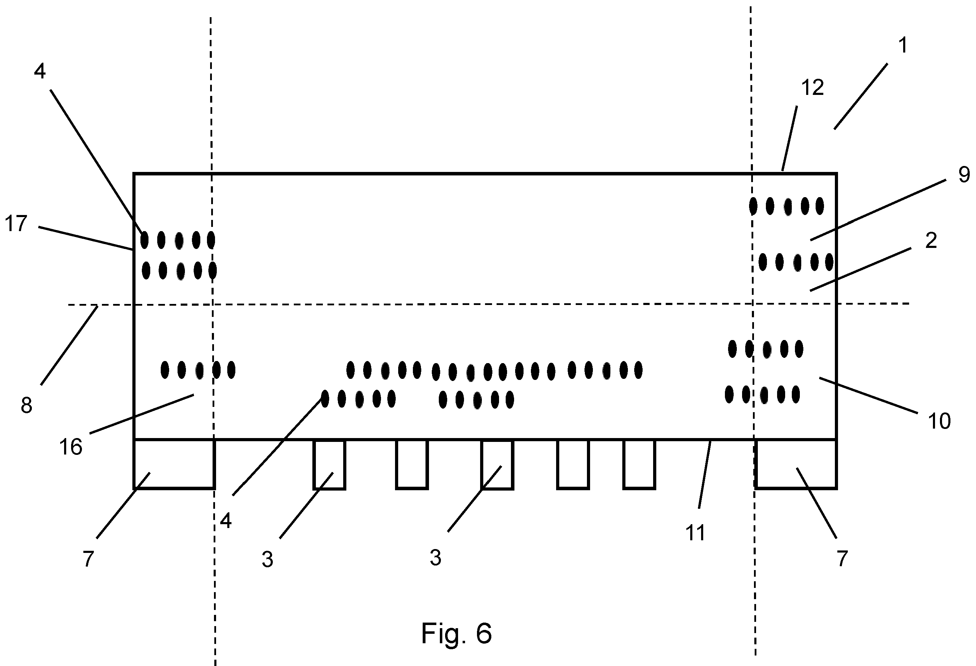

In the embodiment of Figure 5, both the first pixel arrangement 16 and the second pixel arrangement 17 are designed as single-layer or two-dimensional pixel arrangements 16, 17, in which the pixels 4 are thus arranged in a plane parallel to the centre plane 8 or to the front and rear main surfaces 11, 12. However, it is also conceivable that the pixel arrangements 16,17 are three-dimensional or multi-layered, as shown in Figure 6.

In this case, the first pixel arrangement 16 and the second pixel arrangement 17 are not identical, but each of the pixel arrangements 16,17 is individually designed to optimise the flatness or evenness of the mask 1 and to correct placement and/or transmission errors.

In addition, it is also conceivable to relocate at least part of the pixels 4 to areas corresponding to the inactive areas 7 of the mask 1, which are shown in Figure 6 with the dashed lines starting from the inactive surface areas 7, in order to avoid too strong influence of the illumination light of the projection exposure apparatus when transmitting through the mask 1.

Furthermore, it is also conceivable to use the second pixel arrangement 17 not only to compensate for possible deformations caused by the pixels 4 of the first pixel arrangement 16, but to use the first pixel arrangement 16 close to the structures 3 to be imaged to compensate for the errors that require a high spatial resolution, while using the pixels 4 of the second pixel arrangement 17, which are arranged close to the rear or rear main surface 12, to at least co-compensate for errors that require a low spatial resolution of the error compensation.

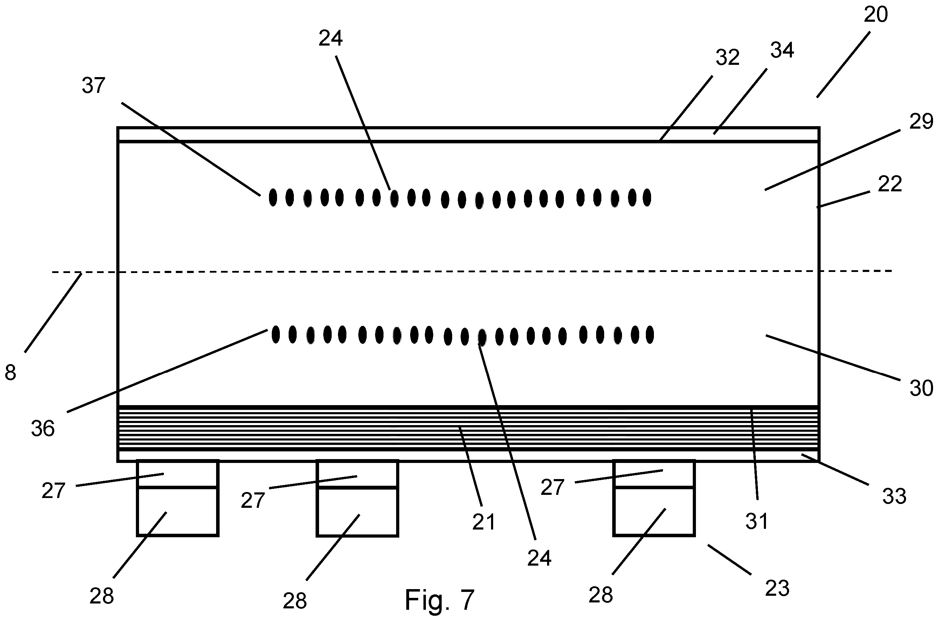

Figure 7 shows another example of an embodiment of the present invention using a reflective mask 20, such as can be used in EUV lithography. Here, too, the representation of the mask 20 corresponds to the representation in Figure 3, and identical components are given the same reference signs. Again, the mask 20 differs in that instead of a single pixel arrangement 26, two pixel arrangements 36 and 37 are arranged, each in one of the halves 29,30 of the substrate 22 defined by the centre plane 8. Accordingly, the area around the centre plane 8 is free of pixels 24 and the pixels 24 of the first pixel arrangement 36 are located in the vicinity of the reflective coating 21 with the structures 23 arranged thereon, while the second pixel arrangement 37 is located in the vicinity of the back surface 32.

As with the transmissive masks 1, the reflective masks 20 may also have more than two pixel arrangements 16,17;36,37, namely both single-layer or two-dimensional pixel arrangements 16,17;36,37 and multi-layer or three-dimensional pixel arrangements 16,17;36,37.

In the embodiment of Figure 7, the two pixel arrangements 36, 37 are again identical and are designed in a single layer or two-dimensionally along a respective plane parallel to the front main surface 31 or the rear main surface 32.

Here, too, the pixels 24 can be generated with different parameters of the laser beam, so that the pixel formation can be influenced and varied.

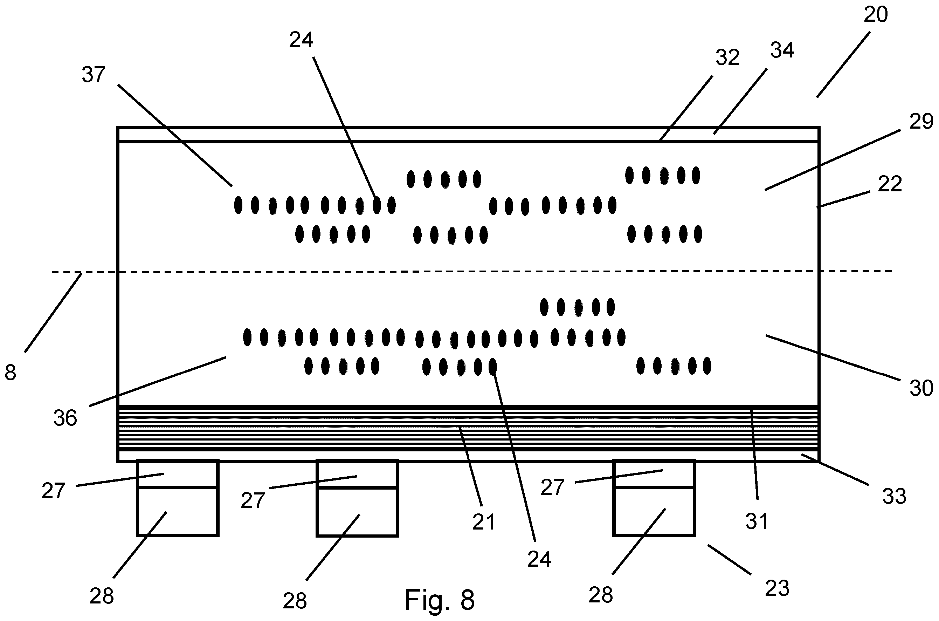

Figure 8 shows a further example of an embodiment, but here again two three-dimensional pixel arrangements 36 and 37 are arranged in the substrate 22 of the reflective mask 20, which in the present case are also not identical.

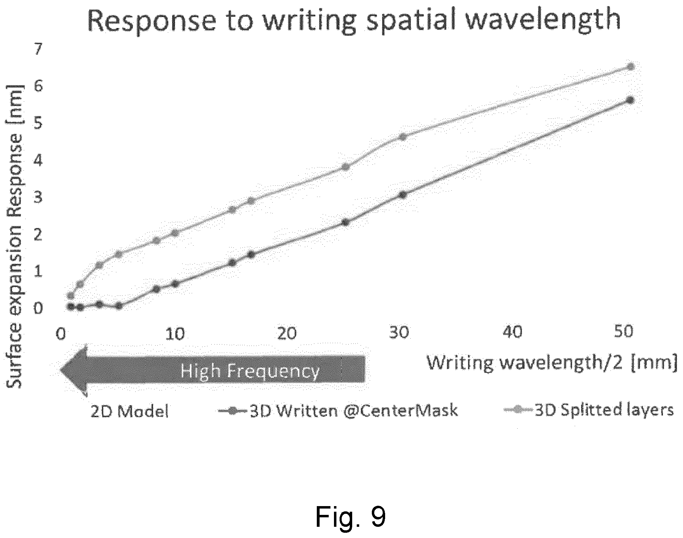

Figure 9 shows the effect of splitting the pixel arrangements into two separate pixel arrangements 16,17;36,37, whereby the surface deformation for three-dimensional pixel arrangements is plotted here as a function of the frequency of pixel generation, i.e. the pixel writing frequency or wavelength. It can be clearly seen that the deformation result on the surface is greater with separated pixel arrangements (upper curve) than with a central, three-dimensional pixel arrangement on the centre plane.

Although the present invention has been described in detail on the basis of the embodiments, it is self-evident to the skilled person that the invention is not limited to these embodiments, but rather that variations are possible in such a way that individual features can be omitted or different combinations of features can be realised without leaving the scope of protection of the appended claims. **In** particular, the present disclosure includes all combinations of the individual features shown in the various embodiments, so that individual features described only in connection with one embodiment can also be used in other embodiment examples or combinations of individual features not explicitly shown.

### REFERENCE LIST

- 1: mask
- 2: substrate
- 3: structures to be imaged
- 4: pixel (local density change)
- 5: laser beam
- 6: pixel arrangement or pixel layer
- 7: non-active part of the mask
- 8: centre plane
- 9: first substrate half
- 10: second substrate half
- 11: front surface or main surface
- 12: rear surface or main surface
- 13: working light of a projection exposure system
- 16: first pixel arrangement
- 17: second pixel arrangement
- 20: mask
- 21: reflective coating
- 22: substrate
- 23: structures to be imaged
- 24: pixel
- 25: laser beam
- 26: pixel arrangement
- 27: buffer layer or structure
- 28: absorbing layer or structure
- 29: first substrate half
- 30: second substrate half
- 31: front surface or major surface
- 32: rear surface or main surface
- 33: cover layer
- 34: back surface coating
- 36: first pixel arrangement
- 37: second pixel arrangement

## Claims

1. A method of correcting placement errors on and/or optical transmission errors of a photolithographic mask (1) for a projection exposure apparatus for microlithography comprising a substrate (2) and structures (3,23) for photolithographic imaging, in which method a plurality of local density variations, each defining a pixel (4, 24), are introduced into the substrate (2) by means of a laser beam (5, 25) in order to correct placement errors of the structures and/or optical transmission errors
**characterised in that**
the pixels are introduced in at least two separately arranged pixel arrangement regions which are arranged outside a centre plane (8) of the substrate (2, 22) or of the mask (1, 20), the pixels (4, 24) being arranged in the pixel arrangement regions in such a way that, with a defined correction of placement errors on and/or of optical transmission errors of the mask (1, 20), an undesired change in shape of the mask (1, 20) is minimised by the introduction of the local density changes.

2. Method according to claim 1,
**characterised in that**
the substrate (2, 22) is in the form of a thin disc which has a length and width or a diameter which are greater than the thickness of the disc by an integral multiple, in particular by a factor of 5 to 50, the width and length of the disc or the areas parallel to the diameter defining the main areas (11,12, 31, 32), wherein the structures to be imaged are arranged on one of the main surfaces (11, 31), wherein in particular the pixel arrangement regions are formed as layers parallel to the main surfaces (11, 12, 31, 32), which comprise pixels in a single layer or in multiple layers.

3. Method according to claim 1 or 2,
**characterised in that**
at least one or exactly one pixel arrangement region is arranged in a substrate half (10, 30) from the centre plane (8) to the main surface (11, 31) with the structures (3, 23) to be imaged, in particular in the vicinity of the main surface with the structures to be imaged, preferably at a distance of one fifth to two thirds of the distance of the main surface with the structures from the centre plane (8), and/or at least one or exactly one pixel arrangement region is arranged in a substrate half (9,29) from the centre plane (8) to the rear side (12, 32) which is opposite the main surface with the structures, in particular in the vicinity of the rear side, preferably at a distance of one fifth to two thirds of the distance of the rear side from the centre plane (8).

4. Method according to any one of the preceding claims,
**characterized in that**
when introducing the pixels (4,24) by means of a laser beam, the laser beam parameters are selected from the group comprising the position of the focal point in the substrate, the numerical aperture of the laser beam, the wavelength of the laser beam used, the writing speed of the laser beam in terms of the number of pixels per time, the focal point size of the laser beam, the beam diameter at the incident surface, the energy of the laser beam, the beam intensity of the laser beam, the intensity profile of the laser beam, the pulse duration, the repetition rate, the pulse power and the pulse power density for pulsed lasers.

5. Method according to any one of the preceding claims,
**characterized in that**
the mask is a transmission mask (1), in particular for a projection exposure system which operates with working light in the range of the deep ultraviolet wavelength spectrum (deep ultraviolet DUV), in particular in the range from 120 nm to 250 nm, or a reflection mask (20), in particular for a projection exposure system which operates with working light in the range of the extreme ultraviolet wavelength spectrum (extreme ultraviolet EUV), in particular in the range from 10 nm to 100 nm.

6. Method according to any one of the preceding claims,
**characterised in that**
for generating the correction of the placement errors and/or of optical transmission errors, the distribution and/or properties of the pixels (4, 24) and/or the laser beam parameters are determined, wherein the determination of the distribution and/or properties of the pixels (4, 24) and/or the laser beam parameters is performed taking into account the undesired shape change or bending to be expected due to the pixels (4, 24).

7. Method according to any one of the preceding claims,
**characterized in that**
two identical pixel arrangements (16,17,36,37) are formed in each half of the substrate (2,22) from the centre plane (8), in particular symmetrically with respect to position and/or arrangement to the centre plane (8).

8. Method according to any one of the preceding claims,
**characterized in that**
in a transmission mask (1) for generating the correction of the placement errors and/or of optical transmission errors, the distribution and/or properties of the pixels (4) and/or the laser beam parameters are determined, the determination of the distribution and/or properties of the pixels and/or the laser beam parameters being carried out taking into account the transmission behaviour of the regions with pixels (4), the undesired change in shape or bending of the substrate due to the introduction of the pixels (4) and the correction of the placement errors and/or of optical transmission errors.

9. A method according to any one of claims 1 to 7,
**characterized in that**
in a reflection mask (20) for generating the correction of the placement errors, the distribution and/or properties of the pixels (24) and/or the laser beam parameters are determined, wherein the determination of the distribution and/or properties of the pixels (24) and/or the laser beam parameters is carried out taking into account the undesired change in shape or bending of the substrate (22) due to the introduction of the pixels (24) and the correction of the placement errors.

10. Method according to any one of the preceding claims,
**characterised in that**
in at least one or exactly one pixel arrangement region in a substrate half (9, 10) from the centre plane (8) to the front side (11) and/or rear side (12, 32) of transmission masks (1), in particular in the vicinity of the rear side, pixels (4) are arranged exclusively or preferably only in one or more lateral parts of the pixel arrangement region, for error correction and/or avoidance of the undesired change in shape or bending of the mask, in particular with a strong density change.

11. Method according to any one of the preceding claims,
**characterized in that**
in order to produce the correction of the placement errors and/or of optical transmission errors, the distribution and/or properties of the pixels and/or the laser beam parameters are determined in such a way that in at least one pixel arrangement region in a substrate half (9, 29) from the centre plane (8) to the rear side (12, 32), which is opposite the main surface with the structures, in particular in the vicinity of the rear side, pixels (4,24) are arranged for correcting errors which require a low spatial resolution, and/or **in that** pixels (4, 24) are arranged in at least one region in a substrate half (10, 30) from the centre plane (8) to the main surface (11, 31) with the structures (3, 23) to be imaged, in particular in the vicinity of the main surface with the structures to be imaged, for correcting errors which require a high spatial resolution.
